# EUROPEAN PATENT APPLICATION

(11) **EP 3 993 019 A1**
(43) Date of publication of application: **04.05.2022**
(21) Application number: 21197027.2
(22) Date of filing: 16.09.2021
(51) Int. Cl.: H01L 21/768, H01L 21/02, H01L 23/522, H01L 23/532

(54) **INTERCONNECT STRUCTURES WITH AREA SELECTIVE ADHESION OR BARRIER MATERIALS FOR LOW RESISTANCE VIAS IN INTEGRATED CIRCUITS**

(30) Priority: 02.11.2020 US 202017087523
(71) Applicant: Intel Corporation, Santa Clara, CA 95054 (US)
(72) Inventor: Jezewski, Christoper, Portland, 97229 (US); Chen, Jiun-Ruey, Portland, 97229 (US); Reshotko, Miriam, Portland, 97221 (US); Blackwell, James M., Portland, 97201 (US); Metz, Matthew, Portland, 97229 (US); Lin, Che-Yun, Beaverton, 97006 (US)
(74) Representative: Goddar, Heinz J.

(57) **Abstract**

Integrated circuit interconnect structures including an interconnect metallization feature with a liner material of a greater thickness between a fill metal and dielectric material, and of a lesser thickness between the fill metal and a lower-level interconnect metallization feature. The liner material may be substantially absent from an interface between the fill metal and the lower-level interconnect metallization feature. Liner material of reduced thickness at a bottom of the via may reduce via resistance and/or facilitate the use of a highly resistive liner material that may enhance the scalability of interconnect structures. In some embodiments, liner material is deposited upon dielectric surfaces with an area selective atomic layer deposition process. For single damascene implementations, both a via and a metal line may include a selectively deposited liner material.

## Description

### BACKGROUND

Demand for higher performance integrated circuits (ICs) in electronic device applications has motivated increasingly dense transistor architectures. Interconnect parasitics become a greater challenge as the density of interconnect structures keeps pace with transistor density. For example, the resistance-capacitance (RC) delay associated with interconnects of an IC increases with the density of the interconnects.

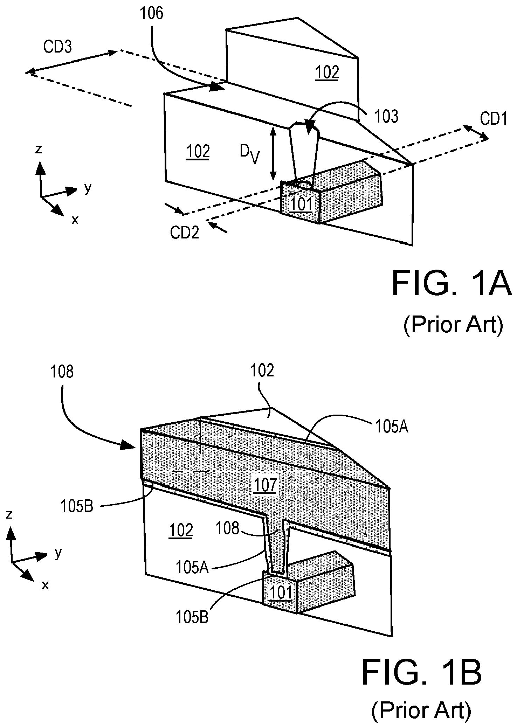

FIG. 1A illustrates a conventional interconnect structure that includes a metal line 101 within a first interconnect level. A transverse width of metal line 101 has some lateral critical dimension CD1. A dielectric material 102 is over metal line 101, and a "via" 103 is subtractively patterned through dielectric material 102 in the z-dimension to expose a portion of metal line 101. Via 103 has a depth DV associated with the thickness of dielectric material 102. A diameter of via 103 has some lateral critical dimension CD2. Often, CD2 is made smaller than CD1 by an amount sufficient to ensure via 103 will land upon metal line 101. The ratio of depth DV to CD2 is referred to as the aspect ratio of via 103. Metal line width CD1 scales down as metal line density increases with increasing transistor density, and so CD2 must also scale down and the aspect ratio of via 103 increases.

As further illustrated in FIG. 1B, via 103 and trench 106 is filled with one or more metals to form a metal line 108 that extends in the x-y dimension to intersect conductive material in via 103 so that two interconnect levels are electrically connected. In this example, a liner material 105 is on surfaces of trench 106 and via 103. Liner material 105 may include a barrier material to prevent diffusion/migration of a fill material 107 out of the interconnect structure, as any loss of fill material 107 is generally catastrophic to an integrated circuit. Liner material may also include an adhesion material instead of a barrier material, or in addition to a barrier material. An adhesion material is to improve adhesion of a fill material 107 that would otherwise suffer poor adhesion with an underlying material, such as a barrier material, and/or dielectric material 102. Whether including a barrier material layer, an adhesion material layer, or both, liner material 105 often has significantly higher electrical resistance than fill material 107. As structural dimensions scale, liner material 105 threatens to become a greater portion of an interconnect structure, leading to higher interconnect resistances.

As shown in FIG. 1B, there is a liner material region 105A in contact with a via sidewall of dielectric material 102 while, and a liner material region 105B on a bottom of via 103. Liner material region 105A is similarly in contact with a trench sidewall of dielectric material 102, and liner material region 105B is similarly on a bottom of trench 106. The liner material region 105B at the intersection of via 103 and line 101 is particularly detrimental to electrical resistance of the interconnect and there is little need for a diffusion barrier material or adhesion material.

With damascene metallization technology, fill metal 107 is deposited (e.g. plated) into trench 106 and/or via 103. Particularly for dual-damascene techniques, it is non-trivial to fabricate an interconnect structure that lessens the electrical impact of liner material 105B while still retaining the benefits of a diffusion barrier and/or adhesion barrier elsewhere within an interconnect structure.

### BRIEF DESCRIPTION OF THE DRAWINGS

The material described herein is illustrated by way of example and not by way of limitation in the accompanying figures. For simplicity and clarity of illustration, elements illustrated in the figures are not necessarily drawn to scale. For example, the dimensions of some elements may be exaggerated relative to other elements for clarity. Further, where considered appropriate, reference labels have been repeated among the figures to indicate corresponding or analogous elements. In the figures:
FIG. 1A and 1B illustrate isometric cross-sectional views of an IC interconnect structure, in accordance with convention;
FIG. 2A is a flow chart of methods of fabricating one level of an integrated circuit interconnect structure having a low resistance via, in accordance with some embodiments;
FIG. 2B is flow chart of methods of selectively depositing an interconnect liner material, in accordance with some embodiments;
FIG. 2C is flow chart of methods of selectively depositing an interconnect liner material, in accordance with some alternative embodiments;
FIG. 2D is flow chart of methods of selectively depositing an interconnect liner material, in accordance with some alternative embodiments;
FIG. 3A, 4A, 5A, and 6A illustrate a plan view of a portion of an IC interconnect structure evolving as the methods illustrated in FIG. 2A are practiced, in accordance with some dual-damascene embodiments;
FIG. 3B, 4B, 5B and 6B illustrate a cross-sectional view of a portion of an IC interconnect structure evolving as the methods illustrated in FIG. 2A are practiced, in accordance with some dual-damascene embodiments;
FIG. 7A, 8A, 9A, and 10A illustrate a plan view of a portion of an IC interconnect structure evolving as the methods illustrated in FIG. 2A are practiced, in accordance with some single-damascene embodiments;
FIG. 7B, 8B, 9B, and 10B illustrate a cross-sectional view of a portion of an IC interconnect structure evolving as the methods illustrated in FIG. 2A are practiced, in accordance with some single-damascene embodiments;
FIG. 11A and 12A illustrate a plan view of a portion of an IC interconnect structure evolving as the methods illustrated in FIG. 2A are practiced, in accordance with some alternative single-damascene embodiments;
FIG. 11B and 12B illustrate a cross-sectional view of a portion of an IC interconnect structure evolving as the methods illustrated in FIG. 2A are practiced, in accordance with some alternative single-damascene embodiments;
FIG. 13 illustrates a mobile computing platform and a data server machine employing an IC including an interconnect structure with low resistance vias, in accordance with some embodiments; and
FIG. 14 is a functional block diagram of an electronic computing device, in accordance with some embodiments.

### DETAILED DESCRIPTION OF EXEMPLARY EMBODIMENTS

Embodiments are described with reference to the enclosed figures. While specific configurations and arrangements are depicted and discussed in detail, it should be understood that this is done for illustrative purposes only. Persons skilled in the relevant art will recognize that other configurations and arrangements are possible without departing from the spirit and scope of the description. It will be apparent to those skilled in the relevant art that techniques and/or arrangements described herein may be employed in a variety of other systems and applications other than what is described in detail herein.

Reference is made in the following detailed description to the accompanying drawings, which form a part hereof and illustrate exemplary embodiments. Further, it is to be understood that other embodiments may be utilized and structural and/or logical changes may be made without departing from the scope of claimed subject matter. It should also be noted that directions and references, for example, up, down, top, bottom, and so on, may be used merely to facilitate the description of features in the drawings. Therefore, the following detailed description is not to be taken in a limiting sense and the scope of claimed subject matter is defined solely by the appended claims and their equivalents.

In the following description, numerous details are set forth. However, it will be apparent to one skilled in the art, that embodiments may be practiced without these specific details. In some instances, well-known methods and devices are shown in block diagram form, rather than in detail, to avoid obscuring the embodiments. Reference throughout this specification to "an embodiment" or "one embodiment" or "some embodiments" means that a particular feature, structure, function, or characteristic described in connection with the embodiment is included in at least one embodiment. Thus, the appearances of the phrase "in an embodiment" or "in one embodiment" or "some embodiments" in various places throughout this specification are not necessarily referring to the same embodiment. Furthermore, the particular features, structures, functions, or characteristics may be combined in any suitable manner in one or more embodiments. For example, a first embodiment may be combined with a second embodiment anywhere the particular features, structures, functions, or characteristics associated with the two embodiments are not mutually exclusive.

As used in the description and the appended claims, the singular forms "a", "an" and "the" are intended to include the plural forms as well, unless the context clearly indicates otherwise. It will also be understood that the term "and/or" as used herein refers to and encompasses any and all possible combinations of one or more of the associated listed items.

The terms "coupled" and "connected," along with their derivatives, may be used herein to describe functional or structural relationships between components. It should be understood that these terms are not intended as synonyms for each other. Rather, in particular embodiments, "connected" may be used to indicate that two or more elements are in direct physical, optical, or electrical contact with each other. "Coupled" may be used to indicated that two or more elements are in either direct or indirect (with other intervening elements between them) physical or electrical contact with each other, and/or that the two or more elements co-operate or interact with each other (e.g., as in a cause and effect relationship).

The terms "over," "under," "between," and "on" as used herein refer to a relative position of one component or material with respect to other components or materials where such physical relationships are noteworthy. For example in the context of materials, one material or layer disposed over or under another may be directly in contact or may have one or more intervening materials or layers. Moreover, one material disposed between two materials or layers may be directly in contact with the two materials/layers or may have one or more intervening materials/layers. In contrast, a first material or layer "on" a second material or layer is in direct contact with that second material/layer. Similar distinctions are to be made in the context of component assemblies.

As used throughout this description, and in the claims, a list of items joined by the term "at least one of' or "one or more of' can mean any combination of the listed terms. For example, the phrase "at least one of A, B or C" can mean A; B; C; A and B; A and C; B and C; or A, B and C.

Described below are examples of integrated circuit interconnect structures that include a metallization feature, such as a line or via, that includes a fill metal and a liner material between the fill metal and a surrounding dielectric material. The liner material may be of a thickness sufficient to function as a fill metal adhesion layer and/or a fill metal diffusion barrier layer. However, the liner material has a lesser thickness (and may be substantially absent) at the intersection of an underlying metallization feature, such as a via or a line. Liner material of greater thickness at a bottom of the metallization feature may, along with liner material on a sidewall of the metallization feature, improve adhesion or mitigate the diffusion of fill metal from the feature into surrounding dielectric material. Regardless of the composition of the liner material, its reduced thickness at the interface between different levels of metallization features may reduce interconnect resistance, and more specifically lower via resistance. As the thickness of liner material across a top and/or bottom of a via is reduced to below some threshold, electrical resistance of the via can be dramatically reduced upon the electron tunneling phenomena becoming significant.

As described below, one or more liner growth inhibition techniques may be integrated into a damascene interconnect process to fabricate an interconnect liner material in a manner that frees a top and/or bottom of a via from the full liner material thickness needed in other areas of the interconnect structure (e.g., sidewall surfaces of metallization lines and vias, and the bottom surface of metallization lines). With the full liner material thickness suppressed outside of the regions of an interconnect structure where an adhesion layer and or diffusion barrier layer is most advantageous, a metal fill and planarization process may then complete a damascene interconnect metallization structure having lower resistance vias.

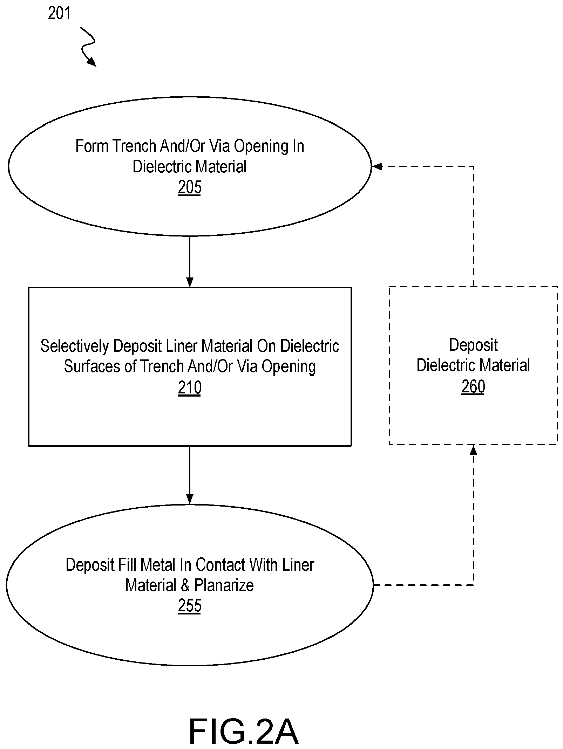

FIG. 2A is a flow chart of methods 201 for fabricating one level of an integrated circuit interconnect structure having a low resistance via, in accordance with some embodiments. Methods 201 may be practiced on a workpiece, such as a large format (e.g., 300-450mm) semiconductor wafer. The wafer may include a Group IV semiconductor material layer (e.g., Si, Ge, SiGe, GeSn, etc.), a Group III-V semiconductor material layer, or a Group II-VI semiconductor material layer, for example. The workpiece may include one or more underlying device layers including a semiconductor material layer, and may also have one or more interconnect levels interconnecting devices (e.g. transistors) of the devices layers.

Methods 201 begin at operation 205 where at least one of a trench or via opening is subtractively patterned into one or more dielectric materials of an IC interconnect structure. The trench and/or via interconnect structure may be any "dual-damascene" or "single-damascene" type structure patterned into any dielectric material(s) suitable as an IC interlayer dielectric material (ILD). In some exemplary embodiments, the trench or via opening is formed in a low-k dielectric material, for example having a relative permittivity less than about 3.5. The trench or via opening may also be formed in a conventional dielectric material a somewhat higher relative permittivity in the range of 3.5-9. The trench or via opening may also be formed in a high-k dielectric material having an even higher relative permittivity, for example exceeding 9.5. In some specific examples, the trench or via opening is formed in any of SiOC, hydrogen silsesquioxane, methyl silsesquioxane, polyimide, polynorbornene, benzocyclobutene SiN, SiO, SiON, HfO2, ZrO, or Al2O3.

In dual-damascene embodiments, both a trench and a via opening are patterned into the dielectric material at block 205. In single-damascene embodiments, only a via opening is patterned in a first iteration of block 205. The trench and/or via opening patterned at operation 205 exposes some underlying interconnect metallization feature. For example, in a dual-damascene interconnect fabrication process, the via opening, but not the trench, exposes some region of an underlying metallization line or via of a lower-level interconnect structure, or exposes some region of an underlying device terminal metallization. In a single-damascene interconnect fabrication process, a via opening exposes some region of an underlying metallization via or line of a lower-level interconnect structure, or exposes some region of an underlying device terminal metallization.

At operation 210 one or more liner material layers are deposited selectively upon dielectric surfaces of the trench and/or via opening. A selective deposition comprises a = deposition or "growth" of liner material on dielectric surfaces than in preference over deposition upon "non-growth" surfaces of a metallization exposed within the trench and/or via opening. In some embodiments, the selectivity of the deposition at operation 210 is at least 3:1 where liner material is formed upon the dielectric surfaces to a thickness at least three times that of liner material formed upon a metallization surface. In some advantageous embodiments, the selectively of the deposition at operation 210 is 5:1, or more. Notably, the thickness of the liner material layer(s) formed upon a metallization surface need not be zero (i.e., may be non-zero). The duration of operation 210 may be controlled to achieve only the threshold minimum thickness upon a dielectric surface needed to function as an adhesion layer and/or barrier layer. The thickness of liner then formed over the metallization surface may be some fraction (e.g., about 1/5-1/3) of the thickness of the functional liner thickness. In some embodiments where a liner is functional as a barrier layer (or adhesion layer) at a minimum thickness threshold of 2 nm, the thickness of the liner formed on metallization surfaces may only be .4-.6 nm, for example. At such thicknesses, the liner may be discontinuous over the metallization surfaces, for example with pinholes, and may provide a minimal tunneling barrier to electrons passing through the interconnect structure.

At operation 255, one or more fill metals are deposited in contact with an uppermost one of the liner materials layers. Any deposition process known to be suitable for depositing a particular fill metal into a trench and/or via opening may be practiced at operation 255 as embodiments herein are not limited in this respect. In some examples, an electrolytic plating process is practiced at operation 255 to deposit a fill metal. In further embodiments, multiple deposition processes may be practiced at operation 255. For example, an electrolytic plating process may be preceded by physical vapor deposition (PVD) of a seed layer. Deposition of the fill metals may also comprise PVD, chemical vapor deposition (CVD), atomic layer deposition (ALD) or electroless plating. For example, a wetting material layer may be deposited by PVD, CVD, ALD or electroless plating prior to the electrolytic plating of a fill metal comprising predominantly copper.

Operation 255 is completed with a planarization of at least the fill metal and the liner material (layers) to expose a top surface of the dielectric material surrounding the trench or via opening. The planarization process may remove any fill metal and liner material from the dielectric material in regions beyond a perimeter of an interconnect structure. Any planarization (e.g., CMP) process may be practiced to complete the metallization of an interconnect feature.

For dual-damascene embodiments, methods 201 is substantially complete following operation 255 with one level of interconnect fabricated. Methods 201 may be repeated for each successive interconnect level that is to include a dual-damascene interconnect structure. Alternatively, in single-damascene embodiments where only a via opening is filled at operation 255, methods 201 continue with operation 260 where a dielectric material is deposited over the interconnect via formed thus far. Any deposition process known to be suitable for forming an ILD may be practiced at operation 260 as embodiments herein are not limited in this respect. Methods 201 then continue with a second iteration of operation 205 where a trench is formed in the dielectric material deposited at operation 260 to expose a portion of the interconnect via. At block 210, one or more liner material layer(s) are again deposited selectively. Hence, for single-damascene embodiments, two selective liner deposition operations 210 may be performed. Methods 201 then complete with a second fill metal operation 255 where one or more fill metals are deposited at planarized to compete one level of interconnect.

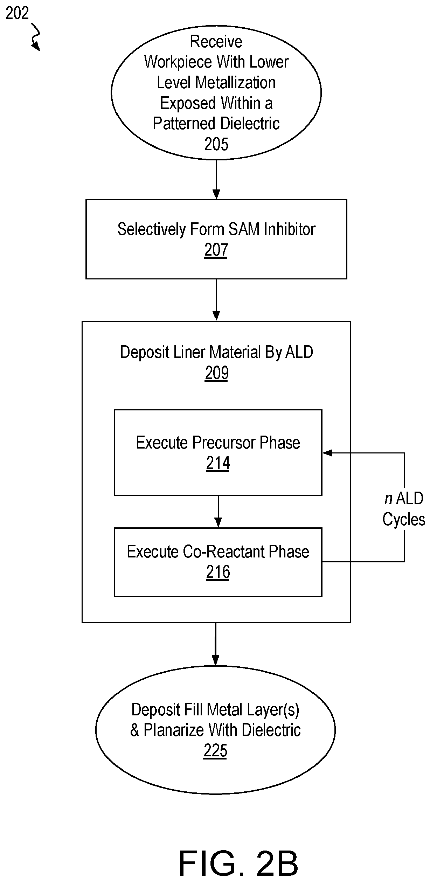

FIG. 2B is flow chart of methods 202 for selectively depositing an interconnect liner material, in accordance with some embodiments. Methods 202 may be practiced at operation 210 in some embodiments of methods 201, for example. Methods 202 may also be practiced at a selective deposition operation in methods other than methods 201, for example.

Methods 202 begin at operation 205 with receipt of a workpiece with some portion of lower-level metallization exposed within a patterned dielectric material. At operation 207 a self-assembled monolayer (SAM) is formed on the exposed surface(s) of the lower-level metallization in preference over exposed dielectric layers. The SAM may have any composition that renders the lower-level metallization surface(s) less suitable for participating in a reaction with a deposition precursor during subsequent a ALD process. Many SAM processes based on heterogeneous surfaces are known. For example, a SAM process may form a monolayer upon hydrophilic surfaces typical of metallization surfaces preferentially over hydrophobic surfaces typical of dielectric materials (e.g., oxides).

Following the SAM pretreatment at operation 205, liner material is deposited by non-selective ALD at operation 209, during which a precursor phase 214 is first executed. A co-reactant phase 216 is then executed. The precursor and co-reactant phases are sensitive to surface chemistry such that the deposition precursor will form upon surfaces uninhibited by the SAM preferentially over surfaces inhibited by the SAM

During precursor phase 214, a precursor of a metal suitable as a metallization barrier and/or adhesion material is introduced into the ALD chamber. In some embodiments, a tantalum precursor, such as, but not limited to, Pentakis(dimethylamido)tantalum, is introduced during precursor phase 214. Tantalum (Ta), as well as metallic compounds of Ta can function as a good diffusion barrier of many interconnect fill metals, such as Cu. In other embodiments, a molybdenum (Mo) or tungsten (W) precursor is introduced during precursor phase 214.

With the precursor molecules adsorbed to uninhibited surfaces of the dielectric material, methods 202 continue with a co-reactant phase 216. During the co-reactant phase, adsorbed precursor molecules are chemically reacted to deposit the liner material, which may be either predominantly a metal or predominantly a metallic compound, such as a metal nitride, metal boride, metal carbide, or the like (e.g., carbon-doped nitride, etc.). In some embodiments, a Ta precursor is reacted with a nitride source, such as ammonia (NH3), to form TaN everywhere the precursor was formed. The co-reactant phase may include a plasma, for example to promote chemical reaction at low temperatures.

Any number of ALD cycles including phases 214 and 216 may be executed at operation 209 to deposit the liner material to a desired target thickness. The inhibitor SAM advantageously survives the precursor and co-reactant phases through a enough of the ALD cycles that the liner deposition has sufficient selectivity (e.g., 3:1-5:1, or more). Following the liner formation, methods 202 complete at operation 225 where the fill metal layer is deposited in contact with the liner material layer(s), and planarized with the surrounding dielectric.

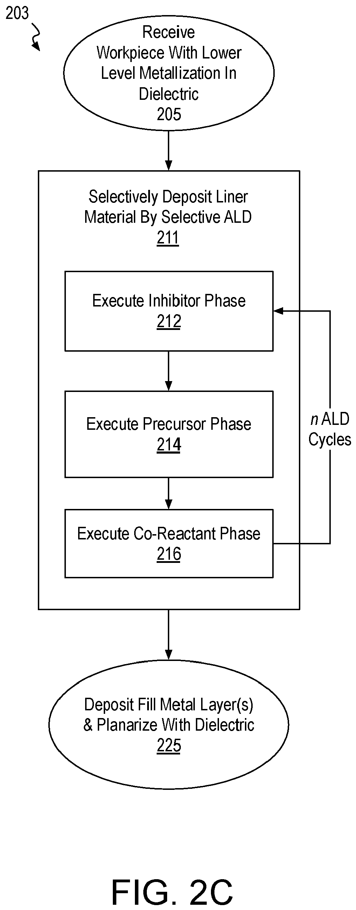

In other embodiments, instead of a SAM inhibitor pretreatment prior to an ALD process, an interconnect liner material is formed with area-selective ALD process. FIG. 2C is flow chart of methods 203 for selectively depositing an interconnect liner material, in accordance with such embodiments. Methods 203 may be practiced at operation 210 in some embodiments of methods 201 (FIG. 2A), for example. Methods 203 may also be practiced at a selective deposition operation in methods other than methods 201, for example.

Methods 203 (FIG. 2C) again begin at operation 205 with receipt of a workpiece with some portion of lower-level metallization exposed with a patterned dielectric material. A selective ALD process is then performed at operation 211. In exemplary embodiment, the selective ALD process includes the precursor phase 214 and the co-reactant phase 216, for example substantially as described above. However, each cycle of the selective ALD process begins with the execution of an inhibitor phase 212, during which an inhibitor molecule is formed on metallization surfaces in preference to dielectric surfaces. Metallization surfaces are preferentially passivated with inhibitor molecules that will retard the adsorption of a deposition precursor introduced in the subsequent precursor phase 214. The inhibitor chemistry may vary with implementation as a function of the material present on the workpiece and/or as a function of the precursor that is to be introduced. In some embodiments, where deposition of a liner material relies on an electrophilic precursor, an inhibitor molecule introduced during the inhibitor phase may render a metallic surface less nucleophilic, which will retard any lewis-base surface reaction with a deposition precursor, thereby inhibiting liner material deposition.

In one exemplary embodiment, during inhibitor phase 212, an aromatic molecule, such as an aniline (C6 H5 NH2) derivative, is introduced to the ALD chamber (in the vapor phase). Because many aromatic molecules display strong adsorption upon transition metal surfaces, they will deposit upon a metal via surface at a much higher rate than upon certain dielectric material surfaces, particularly metal oxides such as, but not limited to HfO2, ZrO2, and Al2O3. A duration of inhibitor phase 212 may be sufficient to inhibit a deposition precursor interactions with the metallization surface(s) but insufficient to similarly inhibit deposition precursor interactions with the dielectric material surface(s).

The precursor and co-reactant phases 212 and 214 may be executed substantially as described above with the inhibitor molecule introduced during inhibitor phase 212 blocking and/or retarding adhesion of the deposition precursor to metallization surfaces of the workpiece. The inhibitor phase 212 may therefore render the precursor phase 214 selective in a manner similar to the SAM pretreatment of methods 202 (FIG. 2B). During precursor phase 214, a precursor of a metal suitable as a metallization barrier and/or adhesion material is introduced into the ALD chamber. In some embodiments, a Ta precursor is introduced during precursor phase 214. In other embodiments, a Mo or W precursor is introduced during precursor phase 214.

During the co-reactant phase 216, adsorbed precursor molecules are chemically reacted to deposit the liner material, which may again be either predominantly a metal or predominantly a metallic compound, such as a metal nitride, metal boride, metal carbide, or the like (e.g., carbon-doped nitride, etc.). Following co-reactant phase 216, a next cycle of selective ALD process 211 begins with execution of another inhibitor phase 212. In exemplary embodiments, no additional phase is present between co-reactant phase 216 and inhibitor phase 212 in selective ALD process 211. For example, no physically energetic phase, such as a sputter phase is executed as part of ALD process 211 as such a non-chemical process is less sensitive to surface chemistry and can also damage exposed interconnect structures. Hence, in some embodiments, ALD process 211 consists essentially of phases 212, 214 and 216 with no other phase in the cycle that materially affects the ALD process. ALD process 211 may however include any number of pump/purges, hold times, and other ancillary activities meant to ensure phases 212, 214 and 216 are adequately implemented.

Any number of ALD cycles including phases 212, 214 and 216 may be executed at operation 211 to deposit the liner material to a desired target thickness. The reducing environment of the co-reactant phase may also induce reactions with inhibitor molecules present on the metallization surfaces. For example, carbon may be removed from aromatic carbon molecules during the co-reactant phase, and so cycling back through inhibitor phase 212 for each additional one of (n) ALD cycles increases the effective selectivity of the liner deposition (e.g., 3:1-5:1, or more). Following the liner formation, methods 203 again complete at operation 225 where the fill metal layer is deposited in contact with the liner material layer(s), and planarized with the surrounding dielectric.

In other embodiments, both a SAM inhibitor pretreatment and an area-selective ALD process is performed to selectively deposit interconnect liner material(s).

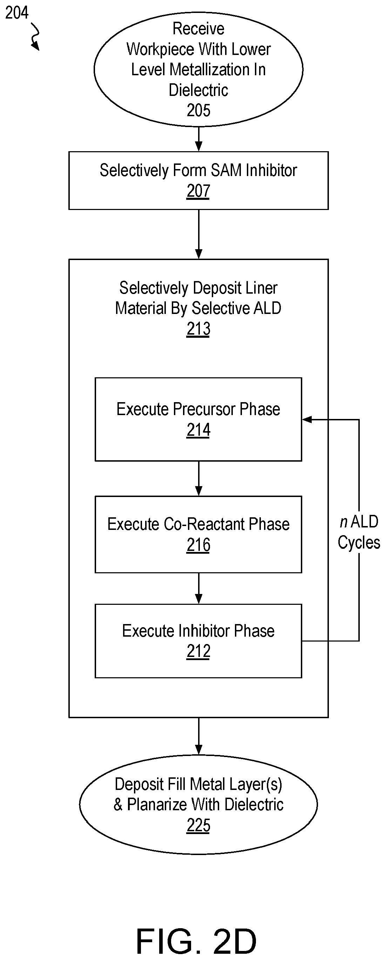

FIG. 2D is flow chart of methods 204 for selectively depositing an interconnect liner material, in accordance with such embodiments. Methods 204 may again be practiced at operation 210 in some embodiments of methods 201 (FIG.2 A), for example. Methods 204 may also be practiced at a selective deposition operation in methods other than methods 201, for example.

Methods 204 again begin at operation 205 with receipt of a workpiece with some portion of lower-level metallization exposed within a patterned dielectric material. A SAM inhibitor is then selectively formed upon metallization surfaces at operation 207, for example substantially as described above. At operation 213, an area selective ALD process is then performed, for example substantially as described above for operation 211. In the illustrated embodiment, the selective ALD process again includes inhibitor phase 212, precursor phase 214 and the co-reactant phase 216, for example substantially as described above. However, for methods 204 the SAM pretreatment at operation 207 provides an initial inhibition of the deposition precursor. At operation 213, a first cycle of precursor phase 214 and co-reactant phase 216 are executed prior to executing a first cycle of inhibitor phase 212. Subsequent ALD cycles then iterate substantially as described above. The SAM pretreatment may therefore provide for at least first ALD cycle having a selectivity attributable to the SAM, while any subsequent ALD cycles rely upon inhibitor phase 212 and the selectivity associated with that inhibition mechanism. Cycling through inhibitor phase 212 is then to maintain a better selectivity than if there was no inhibitor cycle after the SAM inhibitor is lost over the course of nALD cycles. As the number of ALD cycles is advantageously minimized to achieve a minimally sufficient thickness of liner material upon uninhibited dielectric surfaces, any higher selectivity (e.g., 5:1) possible with a SAM pretreatment may significantly improve upon a selectivity (e.g., 3:1-5:1) possible through practice of inhibitor phase 212.

Any number of ALD cycles including phases 214, 216 and 212 may be executed at operation 211 to deposit the liner material to a desired target thickness. Following the liner formation, methods 204 again complete at operation 225 where the fill metal layer is deposited in contact with the liner material layer(s), and planarized with the surrounding dielectric.

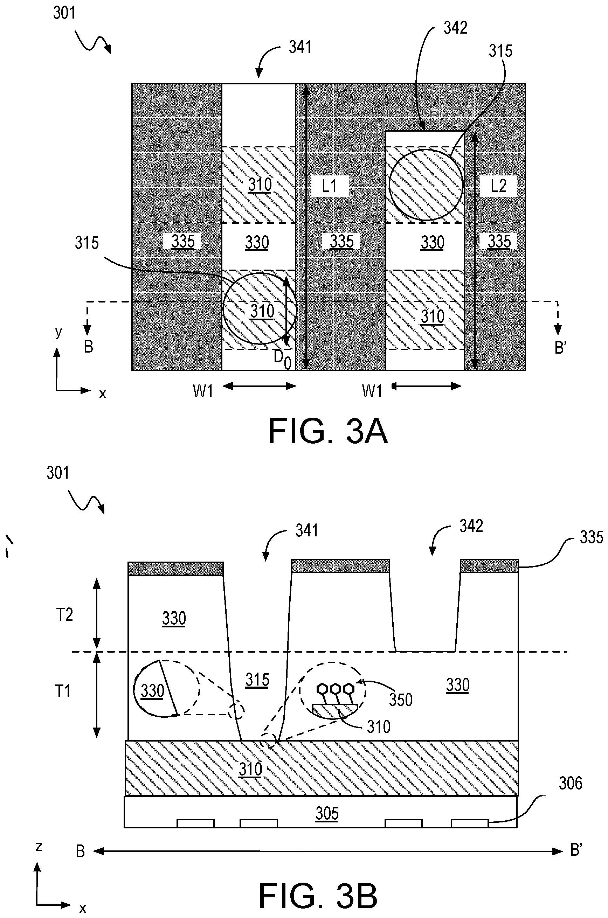

FIG. 3A, 4A, 5A, and 6A illustrate a plan view of a portion of an IC interconnect structure 301 evolving as the methods 201 are practiced, in accordance with some dual-damascene embodiments. FIG. 3B, 4B, 5B and 6B further illustrate a cross-sectional view of a portion of IC interconnect structure 301 evolving, in accordance with some dual-damascene embodiments.

Referring first to FIG. 3A and FIG. 3B, interconnect structure 301 includes a via opening 315 through a thickness T1 of one or more dielectric materials 330. Thickness T1 may vary with implementation, but in some exemplary embodiments is 10nm-50nm. An underlying metallization feature (e.g., a line) 310 is exposed at a bottom of via opening 315. Metallization feature 310 is in a lower interconnect level below dielectric materials 330. Metallization feature 310 may have any composition, with some examples including copper, tungsten, titanium, cobalt, ruthenium, manganese, or aluminum. In FIG. 3A, portions of metallization feature 310 outlined in dashed line are below the surface.

Interconnect structure portion 301 further includes trench 341 over via opening 315, within a thickness T2 of dielectric materials 330. Thickness T2 may vary with implementation, but in some exemplary embodiments is 10-50 nm, or more. Another trench 342 laterally spaced apart from trench 341 is further illustrated, and the cross-section of trench 342 shown in FIG. 3B is representative of a cross-section of trench 341 out of the plane of the FIG. 3B where there is no via opening 315. As shown in FIG. 3A, trench 341 has a longitudinal length L1 and a transverse width W1. In exemplary embodiments, longitudinal length L1 is significantly (e.g., 3x) larger than transverse width W1. Although not illustrated, trench 341 has ends somewhere beyond the perimeter of interconnect structure portion 301. Trench 342 is substantially parallel to trench 341, but with a shorter longitudinal length L2 to further illustrate a trench end. An etch stop material layer 335 is over dielectric materials 330, surrounding trenches 341, 342. Via opening 315 has a maximum lateral diameter D0, which may vary with implementation, but is generally significantly smaller than the length of a trench (e.g., diameter DO is significantly smaller than longitudinal lengths L1 and L2).

Any single-step or multi-step anisotropic reactive ion etch (RIE) process (e.g., based on a CxFy plasma chemistry) may have been practiced to form trenches 341, 342 and via opening 315, as embodiments are not limited in this respect. Trenches 341, 342 and via opening 315 are depicted with a tapered sidewall and positive slope such that a top width of via opening 315 is slightly larger than the bottom width. While such tapered slope is representative of subtractively patterned dielectrics, other profiles are possible as a function of the dielectric etch process.

Dielectric materials 330 may include any dielectric material suitable for electrical isolation of integrated circuitry. Dielectric materials 330, may, for example, be low-k dielectric materials (e.g., SiOC) having a relative permittivity below 3.5. In other examples, dielectric materials 330 may be any of SiO, SiON, hydrogen silsesquioxane, methyl silsesquioxane, polyimide, polynorbornenes, benzocyclobutene, or the like. Dielectric materials 330 may be deposited as a flowable oxide, for example, and have a substantially planar top surface. Etch stop material layer 335 may also be a dielectric material, but advantageously has a different composition than dielectric materials 330. Etch stop material layer 335 may have a somewhat higher relative permittivity than dielectric materials 330, for example. Etch stop material layer 335 may have any composition such as, but not limited to, SiN, SiO, SiON, HfO2, ZrO, Al2O3, for example. Etch stop material layer 335 may have any thickness, but in some advantageous embodiments has a thickness less than 10nm, and advantageously no more than 5nm (e.g., 2-3nm, etc.). In accordance with some further embodiments, dielectric materials 330 may further include an intervening trench etch stop material layer represented as a dashed line between dielectric material thicknesses T1 and T2.

As further shown in FIG. 3B, interconnect structure portion 301 is over a portion of an underlying substrate that includes a device layer 305. Within device layer 305 are a plurality of devices 306. In exemplary embodiments, devices 306 are metal-oxide-semiconductor field effect transistor (MOSFET) structures. However, devices 306 may also be other transistor types, such as, but not limited to other FET architectures, or bipolar junction transistors. Devices 306 may also be other devices that include one or more semiconductor junctions (e.g., diodes, etc.).

FIG. 3B further illustrates an inhibitor 350 adsorbed to the surface of metallization feature 310 exposed at the bottom of via opening 315. Inhibitor 350 is less prevalent on surfaces of dielectric materials 330, and may be substantially absent from a sidewall surface of via opening 315, as well as bottom and sidewall surface of trenches 341, 342. For some embodiments in accordance with methods 202 (FIG. 2B) inhibitor 350 may comprise any molecule derived from an ALD precursor known to be suitable as an inhibitor of ALD deposition precursor surface reactions. In some exemplary embodiments, inhibitor 350 comprises a carbon-based (e.g., aniline) molecule. For some other embodiments in accordance with methods 203 (FIG. 2C) or methods 204 (FIG. 2D), inhibitor 350 may comprise any SAM known to be suitable as an inhibitor of ALD deposition precursor surface reactions.

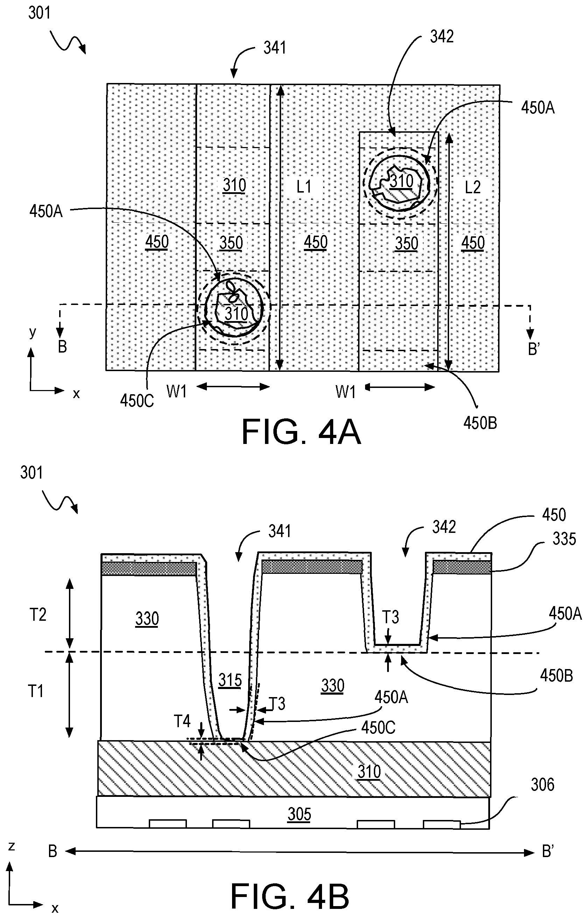

In the example further illustrated in FIG. 4A and FIG. 4B, a liner material 450 has been formed over interconnect structure portion 301. As shown, liner material 450 includes a sidewall liner region 450A within both trench 342 and via opening 315. Sidewall liner region 450A has a thickness T3 sufficient to function as at least one of an adhesion material layer or a diffusion barrier material layer. In some exemplary embodiments, sidewall thickness T3 is at least 1.5nm (e.g., 2-5 nm). Liner bottom region 450B also has the thickness T3. However, liner bottom region 450C only has a lesser thickness T4 where inhibitor 350 was most prevalent. Thickness T4 is significantly thinner than thickness T3, and may be discontinuous as illustrated in FIG. 4A and/or substantially absent (i.e., T4 essentially null). In exemplary embodiments, a thickness ratio of T3:T4 is at least 3:1 and may be 5:1, or more. Hence, in some embodiments where thickness T3 is 2-5 nm, thickness T4 is 0.6-1 nm. These differences in liner material layer thickness are indicative of the a selective deposition process and can reduce electrical resistance attributable to liner material within via bottom region 450C.

In some embodiments, liner material 450 has any composition known to be suitable as a diffusion barrier at thickness T3. In some diffusion barrier examples, liner material 450 comprises a metal, such as, but not limited to, Ta, Mo, W, or Al. In some other embodiments, liner material 450 has any composition known to be suitable as an adhesion layer at thickness T3. In some adhesion layer examples, liner material 450 comprises a metal, such as, but not limited to, W or Pt. Liner material 450 may also comprise a metal compound that further includes at least one of Si, N, C, B, P or O. In some further embodiments, liner material 450 further comprises nitrogen (e.g., TaN, WN, etc.).

Liner material 450 may also comprise one or more dopants such as, but not limited to carbon or boron. In some embodiments, the dopant concentration varies between liner bottom region 450C and one or both of liner sidewall region 450A and liner bottom region 450B. For example, where inhibitor 350 comprises carbon, liner material 450 may comprise more carbon (e.g., TaN:C, TiN:C) within liner bottom region 450C than within liner sidewall region 450A and liner bottom region 450B. While liner sidewall region 450A and/or liner bottom region 450B may have nearly undetectable levels of carbon, the presence of significantly (e.g., >50%) more carbon within liner bottom region 450C may be indicative of an area selective liner deposition process in accordance with embodiments herein. In another example where inhibitor 350 comprises boron or phosphine, liner material 450 may comprise significantly more boron (e.g., TaN:B, TiN:B) or phosphine (e.g., TaN:P, TiN:P) within liner bottom region 45C than within liner sidewall region 450A and/or liner bottom region 450B.

Liner material 450 may be substantially amorphous or may be polycrystalline. For polycrystalline embodiments, the crystallinity of liner material 450 may be significantly greater within liner sidewall region 450A and/or liner bottom region 450B and less within via liner bottom region 450C. Similar to differences in thickness and impurity/dopant content, differences in microstructure between these regions of the liner material are also indicative of a selective liner deposition process.

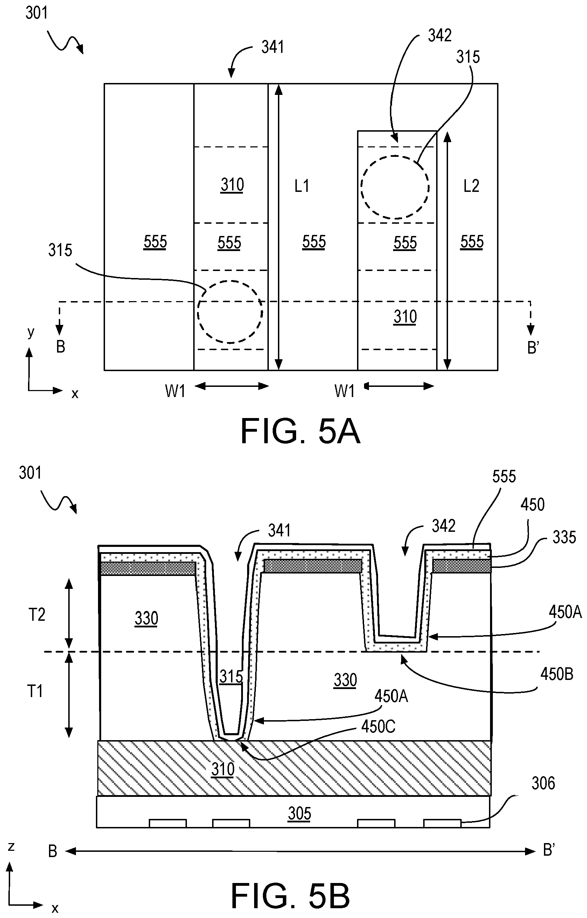

For the example illustrated in FIG. 5A and FIG. 5B, an interconnect metal fill comprises a fill metal layer 555, which may be any metal that may enhance properties of another fill metal. Fill metal layer 555 may function as a wetting layer improving the fill of another fill metal subsequently deposited, for example. In some embodiments, fill metal layer 555 comprises predominantly cobalt. Fill metal layer 555 is in physical contact with an uppermost layer of liner material 450. With the reduced liner material thickness at liner bottom region 450C, at least a portion of fill metal layer 555 may be in direct physical contact with metallization feature 310. If not in direct physical contact, the reduced thickness of liner bottom region 450C significantly reduces the tunneling energy barrier an electron must overcome to tunnel through liner bottom region 450C more. Although fill metal layer 555 is shown as a substantially conformal layer, it may instead completely fill via opening 315 and/or trenches 341 and 342, for example as a function of the thickness of fill metal layer 555 and the lateral dimensions of via opening 315.

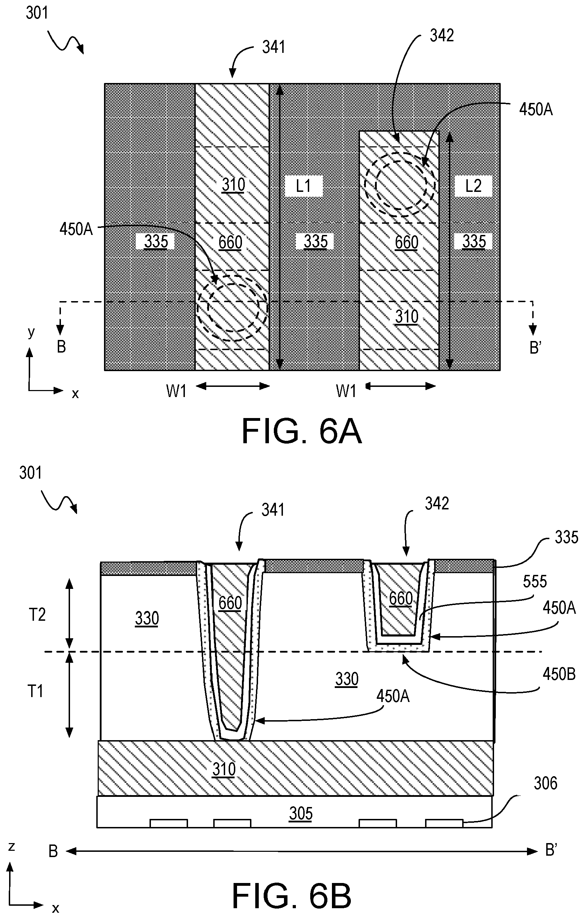

In the example further illustrated in FIG. 6A and FIG. 6B, another fill metal layer 660 substantially backfills both via opening 315 and trenches 341 and 342. In some embodiments, fill metal layer 660 comprises predominantly copper or an alloy thereof. As shown in FIG. 6B, fill metal layers 555 and 660, as well as liner material 450 are substantially planar with a top surface of the workpiece (e.g., etch stop layer 335). As illustrated in FIG. 6A and 6B, interconnect structure 301 includes one level of interconnect metallization comprising a line metallization and via metallization. Interconnect structure 301 may be augmented to have any number of such levels of interconnect metallization as needed for a particular IC.

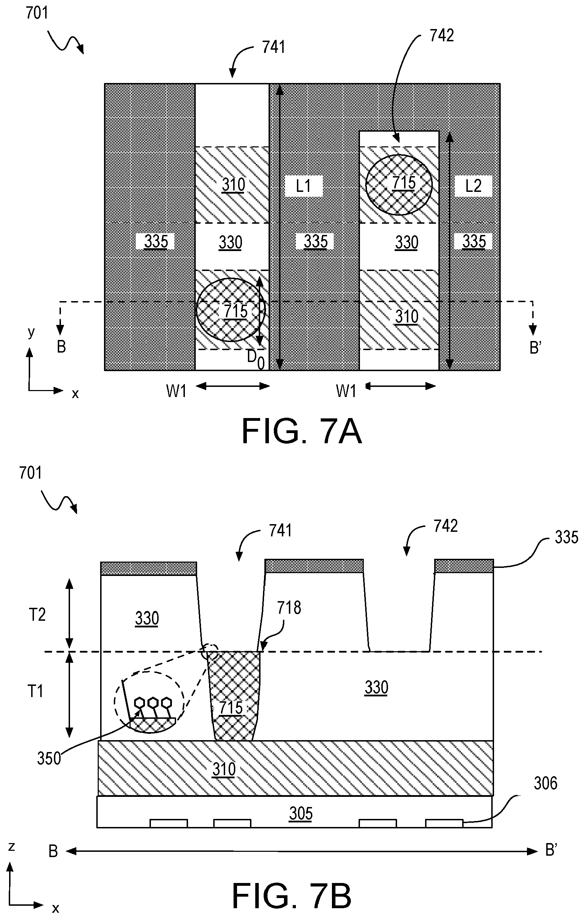

FIG. 7A, 8A, 9A, 10A and 11A illustrate a plan view of a portion of an IC interconnect structure 701 evolving as methods 201 are practiced, in accordance with some single-damascene embodiments. FIG. 7B, 8B, 9B, 10B and 11BA further illustrate a cross-sectional view of a portion of an IC interconnect structure 701, in accordance with some embodiments. Reference numbers are retained where one or more of the attributes introduced above are also applicable to interconnect structure 701.

Referring first to FIG. 7A and FIG. 7B, interconnect structure 701 includes a via 715 extending through a thickness T1 of one or more dielectric materials 330. Via 715 comprises a fill metal that is electrically coupled to underlying metallization feature 310. Via 715 may have been fabricated according to a first single-damascene process, for example. Via 715 has no liner, and may comprise any fill metal suitable for a linerless via, such as, but not limited to, tungsten, molybdenum, titanium, cobalt, or ruthenium, for example. Without a liner, the via fill metal is in physical contact with metallization feature 310. A top surface of via 715 is exposed at a bottom of trench 741 patterned into dielectric materials 330. As a result of separate patterning of via 715 and trench 741, there is a non-zero lateral offset or profile discontinuity 718 at the interface of the sidewall of trench 741 and a sidewall of via 715. Etch stop material layer 335 is again over dielectric materials 330, surrounding trenches 341, 742. As further shown in FIG. 7B, interconnect structure portion 701 is again over a portion of an underlying substrate that includes a device layer 305. Within device layer 305 are a plurality of devices 306.

FIG. 7B further illustrates inhibitor 350 adsorbed to the surface of via 715 that is exposed at the bottom of trench 741. Inhibitor 350 is again less prevalent on surfaces of dielectric materials 330, and may be substantially absent from the dielectric surfaces of trenches 741, 742. Inhibitor 350 may again comprise any molecular inhibitor derived from an ALD precursor or a SAM pretreatment performed upstream of a cyclic ALD process.

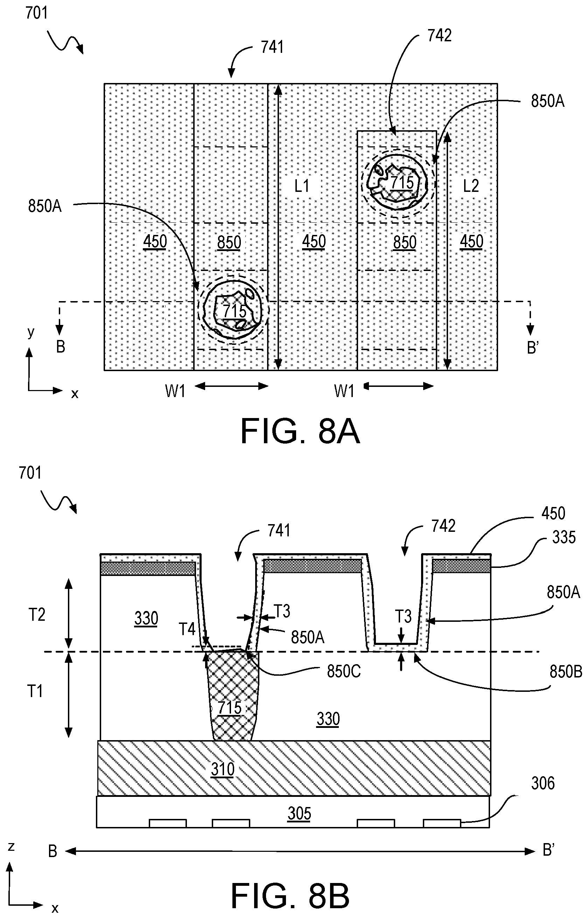

In the single-damascene example further illustrated in FIG. 8A and FIG. 8B, liner material 450 includes a liner sidewall region 850A adjacent to dielectric sidewall surfaces of trenches 741, 742. Liner sidewall region 850A has thickness T3 sufficient to function as at least one of an adhesion material layer or a diffusion barrier material layer. In some exemplary embodiments, sidewall thickness T3 is at least 1.5nm (e.g., 2-5 nm). Liner bottom region 850B also has the thickness T3 over dielectric surfaces of the bottom of trenches 741, 742. However, liner bottom region 850C has the lesser thickness T4 over via 715 where inhibitor 350 was most prevalent. As noted above, thickness T4 is significantly thinner than thickness T3, and liner material within liner bottom region 850C may be discontinuous as illustrated in FIG. 8A and/or substantially absent (i.e., T4 essentially null). In exemplary embodiments, a thickness ratio of T3:T4 is at least 3:1 and may be 5:1, or more. Liner material 450 may have any of the compositions and/or compositional variations, microstructure and/or microstructural variations described above in the context of a dual-damascene interconnect structure.

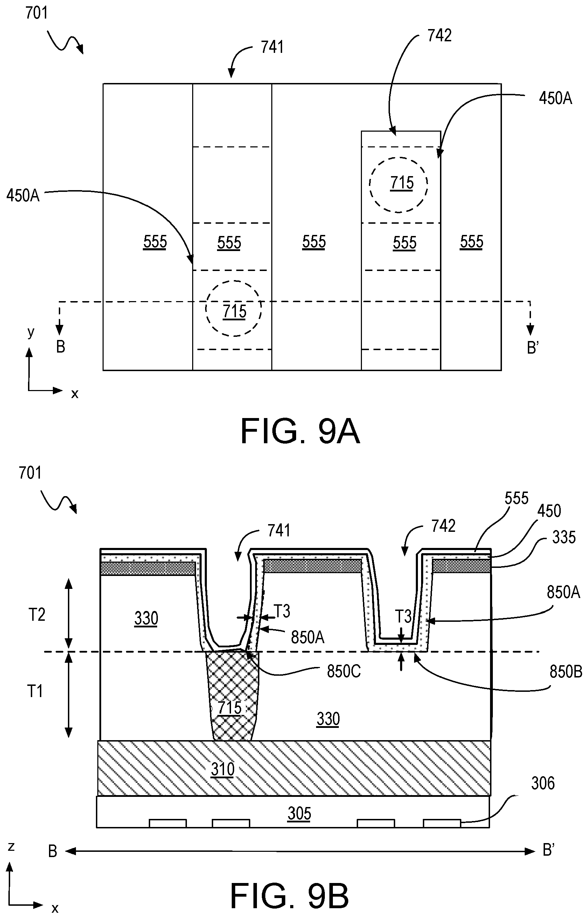

As further illustrated in FIG. 9A and FIG. 9B, metal fill comprises fill metal layer 555. As noted above, fill metal layer 555 may comprise any metal but in some examples is predominantly cobalt. With the reduced liner material thickness at liner bottom region 850C, some portion of fill metal layer 555 may be in direct physical contact with via 715. If not in direct physical contact, the reduced thickness of liner bottom region 850C may increase electron tunneling through the liner material layer(s). Although fill metal layer 555 is shown as a substantially conformal layer, it may instead completely fill trenches 741 and 742, for example as a function of the thickness of fill metal layer 555 and the lateral dimensions of trenches 741, 742.

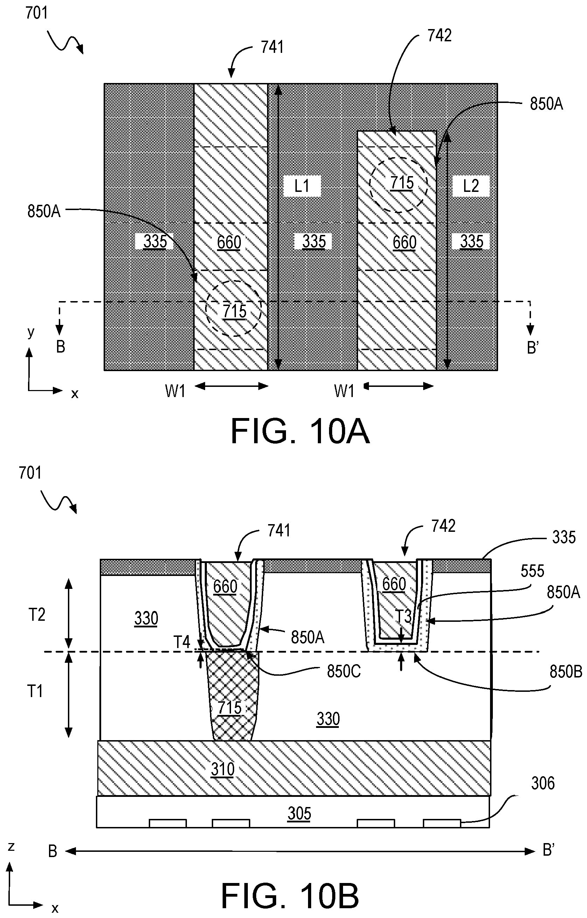

In the example further illustrated in FIG. 10A and FIG. 10B, fill metal layer 660 substantially backfills trenches 741 and 742. Fill metal layers 555 and 660, as well as liner material 450 are substantially planar with a top surface of the workpiece (e.g., etch stop layer 335). Interconnect structure 701 is therefore a single damascene structure associated with one level of interconnect metallization comprising a line metallization and via metallization. Interconnect structure 701 may be augmented to have any number of such levels of interconnect metallization as needed for a particular IC.

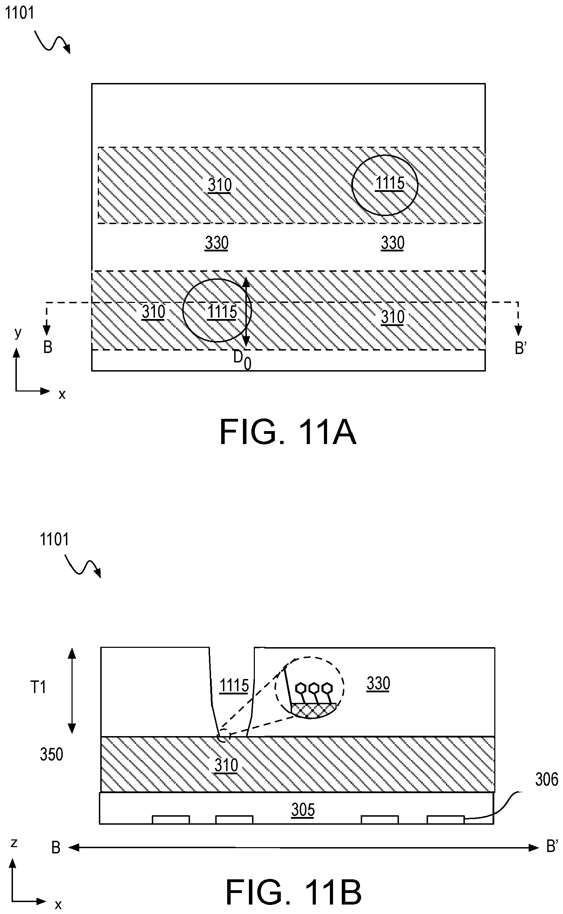

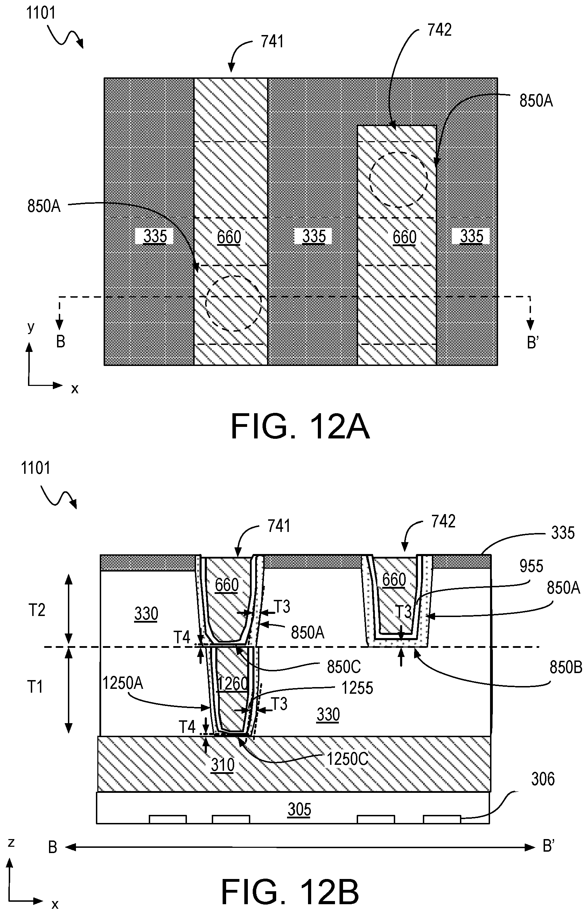

For some single-damascene structures, an interconnect line may have a liner of minimal thickness with an underlying interconnect via metallization, for example as illustrated in FIG. 7A-10. Some single-damascene structures may also include a via having a liner of minimal thickness with an underlying interconnect line metallization. FIG. 11A and FIG. 12A illustrate a plan view of an interconnect structure 1101 evolving to include two area selective liners as methods 201 are practiced in accordance with some single-damascene embodiments. FIG. 11B and 12B illustrate corresponding cross-sectional views of interconnect structure 1101, in accordance with some embodiments.

As shown in FIG. 11A and FIG. 11B, interconnect structure 1101 includes a via opening 1115 extending through a thickness T1 of one or more dielectric materials 330.

FIG. 11B illustrates inhibitor 350 upon the surface of metallization feature 310 exposed at the bottom of via opening 1115, for example substantially as described above in the context of a dual-damascene interconnect structure. A first liner may then be selectively deposited into via opening 1115. Hence two iterations of methods 201 (FIG. 2A) may be practiced to selectively form a liner for each of both a via and a metallization line.

FIG. 12A and FIG. 12B illustrate a substantially complete single-damascene interconnect structure 1101 including a via liner having a sidewall region 1250A of thickness T3 between a via fill metal 1255 and a sidewall of dielectric materials 330. The via liner material further has a liner bottom region 1250C with lesser thickness T4. Interconnect structure 1101 further includes a trench liner having liner sidewall region 850A of thickness T3, and liner bottom region 850C with thickness T4. Although via and trench liner materials may be different, in some exemplary embodiments the two liner materials have substantially the same composition (e.g., TaN). As further illustrated in FIG. 12B, liner bottom region 1250C, if present at all, has only a minimal thickness T3 between a via fill metal layer 1255 (e.g. Co) and metallization feature 310. Similarly, liner bottom region 850A, if present at all, has only a minimal thickness T3 between trench fill metal layer 555 and via fill metal layer 1260 (e.g., Cu). In this example, the reduced thickness of liner bottom regions 1250C and 850C (2^{∗}T3) both contribute to a total electrical resistance between interconnect lines of adjacent interconnect levels that is significantly lower than if the liner bottom regions 1250C and 850C instead had the full liner thicknesses (2^{∗}T4).

Interconnect structures 301, 701, or 1101 may each be incorporated into any IC circuitry as a portion of any IC chip or die that may be singulated from a workpiece following the completion of any conventional processing not further described herein. With area selective liner material at a bottom of via metallization and/or line metallization interconnect metallization resistance, and more particularly via electrical resistance, may be reduced. IC circuitry may therefore display an lower RC delay and higher overall performance. An IC may also display lower power consumption and lower temperatures for a given level of performance.

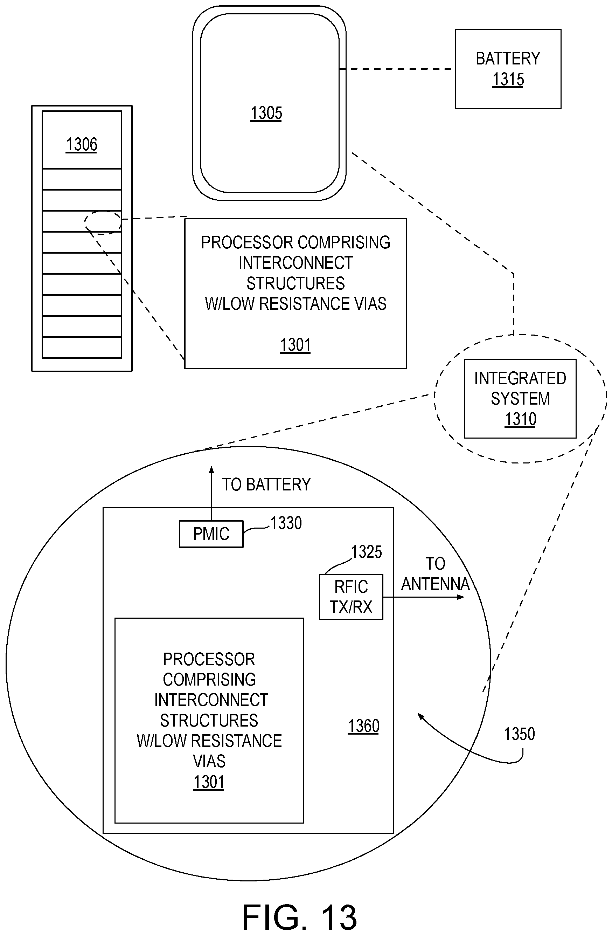

FIG. 13 illustrates a mobile computing platform 1305 and a data server computing platform 1306 employing an IC including interconnect structures with low resistance vias, for example as described elsewhere herein. The server platform 1306 may be any commercial server, for example including any number of high-performance computing platforms disposed within a rack and networked together for electronic data processing, which in the exemplary embodiment includes a microprocessor 1301 including interconnect structures with low resistance vias, for example as described elsewhere herein.

The mobile computing platform 1305 may be any portable device configured for each of electronic data display, electronic data processing, wireless electronic data transmission, or the like. For example, the mobile computing platform 1305 may be any of a tablet, a smart phone, laptop computer, etc., and may include a display screen (e.g., a capacitive, inductive, resistive, or optical touchscreen), a chip-level or package-level integrated system 1310, and a battery 1315. At least one IC of chip-level or package-level integrated system 1310 includes an interconnect structure with low resistance vias, for example as described elsewhere herein. In the example shown in expanded view 1350, integrated system 1310 includes microprocessor 1301 including interconnect structures with low resistance vias, for example as described elsewhere herein. Microprocessor 1350 may be further coupled to a board 1360, a substrate, or an interposer. One or more of a microcontroller 1335, a power management integrated circuit (PMIC) 1330, or an RF (wireless) integrated circuit (RFIC) 1325 including a wideband RF (wireless) transmitter and/or receiver (TX/RX) may be further coupled to board 1360.

Functionally, PMIC 1330 may perform battery power regulation, DC-to-DC conversion, etc., and so has an input coupled to battery 1315 and with an output providing a current supply to other functional modules (e.g., microprocessor 1350). As further illustrated, in the exemplary embodiment, RFIC 1325 has an output coupled to an antenna (not shown) to implement any of a number of wireless standards or protocols, including but not limited to Wi-Fi (IEEE 802.11 family), WiMAX (IEEE 802.16 family), IEEE 802.20, long term evolution (LTE), Ev-DO, HSPA+, HSDPA+, HSUPA+, EDGE, GSM, GPRS, CDMA, TDMA, DECT, Bluetooth, derivatives thereof, as well as any other wireless protocols that are designated as 4G, 5G, and beyond.

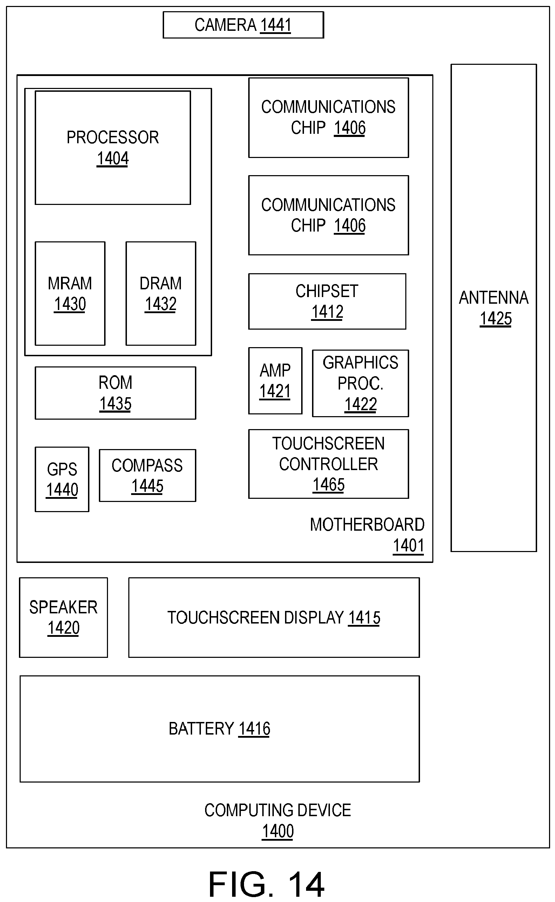

FIG. 14 is a functional block diagram of an electronic computing device 1400, in accordance with an embodiment of the present invention. Computing device 1400 may be found inside platform 1305 or server platform 1306, for example. Device 1400 further includes a motherboard 1401 hosting a number of components, such as, but not limited to, a processor 1404 (e.g., an applications processor). Processor 1404 may be physically and/or electrically coupled to motherboard 1401. In some examples, processor 1404 includes interconnect structures with low resistance vias, for example as described elsewhere herein. In general, the term "processor" or "microprocessor" may refer to any device or portion of a device that processes electronic data from registers and/or memory to transform that electronic data into other electronic data that may be further stored in registers and/or memory.

In various examples, one or more communication chips 1406 may also be physically and/or electrically coupled to the motherboard 1401. In further implementations, communication chips 1406 may be part of processor 1404. Depending on its applications, computing device 1400 may include other components that may or may not be physically and electrically coupled to motherboard 1401. These other components include, but are not limited to, volatile memory (e.g., DRAM 1432), non-volatile memory (e.g., ROM 1435), flash memory (e.g., NAND or NOR), magnetic memory (MRAM 1430), a graphics processor 1422, a digital signal processor, a crypto processor, a chipset 1412, an antenna 1425, touchscreen display 1415, touchscreen controller 1465, battery 1416, audio codec, video codec, power amplifier 1421, global positioning system (GPS) device 1440, compass 1445, accelerometer, gyroscope, speaker 1420, camera 1441, and mass storage device (such as hard disk drive, solid-state drive (SSD), compact disk (CD), digital versatile disk (DVD), and so forth), or the like. In some exemplary embodiments, at least one of the functional blocks noted above include interconnect structures with low via resistance, for example as described elsewhere herein.

Communication chips 1406 may enable wireless communications for the transfer of data to and from the computing device 1400. The term "wireless" and its derivatives may be used to describe circuits, devices, systems, methods, techniques, communications channels, etc., that may communicate data through the use of modulated electromagnetic radiation through a non-solid medium. The term does not imply that the associated devices do not contain any wires, although in some embodiments they might not. Communication chips 1406 may implement any of a number of wireless standards or protocols, including but not limited to those described elsewhere herein. As discussed, computing device 1400 may include a plurality of communication chips 1406. For example, a first communication chip may be dedicated to shorter-range wireless communications, such as Wi-Fi and Bluetooth, and a second communication chip may be dedicated to longer-range wireless communications such as GPS, EDGE, GPRS, CDMA, WiMAX, LTE, Ev-DO, and others.

It will be recognized that the invention is not limited to the embodiments so described, but can be practiced with modification and alteration without departing from the scope of the appended claims. For example the above embodiments may include specific combinations of features as further provided below.

In first examples, an integrated circuit (IC) interconnect structure comprises a first line metallization, a dielectric material over the first line metallization, a via metallization through the dielectric material, and coupled to the first line metallization, and a second line metallization over, and coupled to, the first line metallization through the via metallization. The second line metallization comprises a fill metal, a first thickness of a liner material between a bottom of the fill metal and the dielectric material, and a second thickness of the liner material between a bottom of the fill metal and the via metallization. The second thickness is less than half of the first thickness, and comprises a higher atomic concentration of C, P, or B than the first thickness of the liner material.

In second examples, for any of the first examples the first thickness is at least 2 nm, and the second thickness is less than 20% of the first thickness.

In third examples, for any of the first through third examples the second thickness is less than 1 nm.

In fourth examples, for any of the first through third examples the liner material comprises at least one of Ta, Mo, or W.

In fifth examples, for any of the fourth examples the liner material further comprises nitrogen.

In sixth examples, for any of the fifth examples the first thickness of the liner material comprises predominantly Ta, and N.

In seventh examples, for any of the fifth or sixth examples the second thickness of the liner material or the barrier material comprises C.

In eighth examples, for any of the first through seventh examples the via metallization comprises the fill metal, and the via metallization comprises a third thickness of the liner material in physical contact with the dielectric material.

In ninth examples, for any of the eighth examples a fourth thickness of the liner material is between the fill metal of the via metallization and the first line metallization.

In tenth examples, for any of the ninth examples the third thickness is at least 2 nm, and the fourth thickness is less than 20% of the third thickness.

In eleventh examples, for any of the tenth examples the fourth thickness is less than 1 nm.

In twelfth examples, for any of the eleventh examples the third thickness is substantially equal to the first thickness and the fourth thickness is substantially equal to the second thickness.

In thirteenth examples, for any of the first through twelfth examples the fill metal comprises Cu, and the via metallization comprises at least one of Cu, W, or Ru.

In fourteenth examples, a computer platform comprises a power supply, and an integrated circuit (IC) coupled to the power supply. The IC comprises a device layer comprising a plurality of transistors comprising one or more semiconductor materials, and the IC comprises a plurality of interconnect levels. The interconnect levels further comprise a first line metallization, a dielectric material over the first line metallization, a via metallization through the dielectric material, and coupled to the first line metallization, and a second line metallization over, and coupled to, the first line metallization through the via metallization. The second line metallization comprises a fill metal, a first thickness of a liner material between the fill metal and the dielectric material, and a second thickness of the liner material between the fill metal and the via metallization. The second thickness is less than half of the first thickness, and comprises a higher atomic concentration of C, P, or B than the first thickness of the liner material.

In fifteenth examples, for any of the fourteenth examples the IC comprises a microprocessor.

In sixteenth examples, a method of fabricating an integrated circuit (IC) interconnect structure comprises exposing a region of a metallization feature by forming at least one of a via opening or a trench in a dielectric material. The method comprises forming, with a selective atomic layer deposition (ALD) process, a first thickness of a liner material upon a surface of the dielectric material, and a second thickness of the liner material upon a surface of the metallization feature, wherein the second thickness is less than half of the first thickness, and comprises a higher atomic concentration of C, P, or B than the first thickness of the liner material. The method comprises depositing a fill metal within the via opening or the trench, and planarizing the fill metal with the dielectric material.

In seventeenth examples, for any of the sixteenth examples the ALD process comprises reacting metallic material surfaces with an inhibitor, reacting dielectric surfaces with a metallic precursor, and reacting the metallic precursor with a co-reactant to form a metallic material.

In eighteenth examples, for any of the sixteenth through seventeenth examples the metallic material comprises Ta and N.

In nineteenth examples, for any of the sixteenth through eighteenth examples the inhibitor comprises at least one of C, B, or P.

In twentieth examples, for any of the nineteenth examples the inhibitor comprises aniline.

In twenty-first examples, for any of the nineteenth examples forming the second thickness of the liner material comprises forming the metallic material doped with the at least one of C, B, or P.

In twenty-second examples, for any of the twenty-first examples the method further comprises forming a self-assembled monolayer (SAM) on the surface of the metallization feature prior to performing the selective ALD process.

While certain features set forth herein have been described with reference to various implementations, this description is not intended to be construed in a limiting sense. Hence, various modifications of the implementations described herein, as well as other implementations, which are apparent to persons skilled in the art to which the present disclosure pertains are deemed to lie within the spirit and scope of the present disclosure.

## Claims

1. An integrated circuit (IC) interconnect structure, comprising:
a first line metallization;
a dielectric material over the first line metallization;
a via metallization through the dielectric material, and coupled to the first line metallization; and
a second line metallization over, and coupled to, the first line metallization through the via metallization, wherein the second line metallization comprises:
a fill metal;
a first thickness of a liner material between the fill metal and the dielectric material; and
a second thickness of the liner material between the fill metal and the via metallization, wherein the second thickness is less than half of the first thickness, and comprises a higher atomic concentration of C, P, or B than the first thickness of the liner material.

2. The IC interconnect structure of claim 1, wherein the first thickness is at least 2 nm, and the second thickness is less than 20% of the first thickness.

3. The IC interconnect structure of any one of claims 1-2, wherein the second thickness is less than 1 nm.

4. The IC interconnect structure of any one of claims 2-3, wherein the liner material comprises at least one of Ta, Mo, or W.

5. The IC interconnect structure of claim 4, wherein the liner material further comprises nitrogen.

6. The IC interconnect structure of claim 5, wherein the first thickness of the liner material comprises predominantly Ta, and N.

7. The IC interconnect structure of any one of claims 5-6, wherein the second thickness of the liner material or the barrier material comprises C.

8. The IC interconnect structure of any one of claims 1-7, wherein the via metallization comprises the fill metal, and the via metallization comprises a third thickness of the liner material in physical contact with the dielectric material.

9. The IC interconnect structure of claim 8, wherein a fourth thickness of the liner material is between the fill metal of the via metallization and the first line metallization.

10. The IC interconnect structure of claim 9, wherein the third thickness is at least 2 nm, and the fourth thickness is less than 20% of the third thickness.

11. The IC interconnect structure of claim 10, wherein the fourth thickness is less than 1 nm.

12. The IC interconnect structure of claim 11, wherein the third thickness is substantially equal to the first thickness and the fourth thickness is substantially equal to the second thickness.

13. The IC interconnect structure of any one of claims 1-12, wherein the fill metal comprises Cu, and the via metallization comprises at least one of Cu, W, or Ru.

14. A method of fabricating an integrated circuit (IC) interconnect structure, the method comprising:
exposing a region of a metallization feature by forming at least one of a via opening or a trench in a dielectric material;
forming, with a selective atomic layer deposition (ALD) process, a first thickness of a liner material upon a surface of the dielectric material, and a second thickness of the liner material upon a surface of the metallization feature, wherein the second thickness is less than half of the first thickness, and comprises a higher atomic concentration of C, P, or B than the first thickness of the liner material;
depositing a fill metal within the via opening or the trench; and
planarizing the fill metal with the dielectric material.

15. The method of claim 14, wherein the ALD process comprises:
reacting metallic material surfaces with an inhibitor;
reacting dielectric surfaces with a metallic precursor; and
reacting the metallic precursor with a co-reactant to form a metallic material.
